(19) Europäisches Patentamt

European Patent Office

Office européen des brevets

(11) Publication number: **0 366 784 B1**

## EUROPEAN PATENT SPECIFICATION

(45) Date of publication of patent specification: **29.11.95**

(51) Int. Cl.⁶: **B22F 7/04**, C06B 45/30, B01J 25/00, H01M 4/98

(21) Application number: **89906655.9**

(22) Date of filing: **18.04.89**

(86) International application number: **PCT/US89/01655**

(87) International publication number: **WO 89/10340 (02.11.89 89/26)**

(54) **ACTIVATED METAL AND METHOD.**

(30) Priority: **18.04.88 US 182718**
**10.06.88 US 205387**
**22.12.88 US 289595**
**10.04.89 US 335240**

(43) Date of publication of application:
**09.05.90 Bulletin 90/19**

(45) Publication of the grant of the patent:
**29.11.95 Bulletin 95/48**

(84) Designated Contracting States:
**AT BE CH DE FR GB IT LI LU NL SE**

(56) References cited:
**US-A- 3 637 437**
**US-A- 4 292 208**
**US-A- 4 349 612**
**US-A- 4 820 362**
**US-A- 4 830 931**

(73) Proprietor: **ALLOY SURFACES COMPANY, INC.**
**100 Locke Road**
**Edgemoor**
**Wilmington**
**Delaware 19809 (US)**

(72) Inventor: **BALDI, Alfonso, L.**
**514 East Lancaster Avenue, C-5**
**Wynnewood, PA 19096 (US)**

(74) Representative: **Williams, John Francis et al**
**WILLIAMS, POWELL & ASSOCIATES**
**34 Tavistock Street**
**London WC2E 7PB (GB)**

EP 0 366 784 B1

**Description**

The present invention relates to the preparation of activated metals, and more particularly metals that are highly reactive and/or very good catalysts.

Among the objects of the present invention is the provision of novel methods for effecting the activation. Additional objects of the present invention include the provision of novel forms of activated metal.

U.S. Patent No. 3,637,437 is directed to spraying a Raney alloy on a substrate and then leaching aluminum from the alloy. It is clear from the teachings of this patent that the metal particles that are sprayed on the substrate are Raney alloys and not precursors thereof. This method is different from the method of the present invention wherein the Raney alloys are formed in situ on the surface of the carrier web by first applying to the carrier web a mixture of aluminum powder and nickel, iron or cobalt powder (i.e., the precursors to the Raney alloy), wherein the powders are in the proportion of a Raney alloy, and then heating the powder particles so as to cause the essentially complete interaction of the metal powders to form a Raney alloy which adheres to the carrier web.

According to the present invention, a process for preparing a length of pyrophoric material, comprises the steps of providing a length of a carrier in the form of a web or foil not over about 3/4 millimeter thick, applying to the carrier a layer at least about 1/50 millimeter thick of a mixture of aluminum powder and nickel, iron or cobalt powder, the powders being in the proportion of a Raney alloy, and the powder particles being sufficiently small to essentially completely interact when heated, heating the carrier to cause the powder particles to essentially completely interact to form aluminides that are sintered together and adhere to the carrier the latter being sufficiently heat resistant so that it is not disintegrated by the process and leaching some of the aluminum from the aluminides to form the pyrophoric material.

Claims 2 to 15 relate to preferred embodiments of the process of the invention.

Claims 16 to 19 are directed to pyrophoric foils which may be prepared by the process of the invention.

The foregoing as well as further objects of the present invention will be more fully understood from the following description of several of its exemplifications, reference being made to the accompanying drawings in which:

Fig 1 is a sectional view, highly enlarged, of an activated product pursuant to the present invention:

Fig 2 is a schematic production line for producing the product of Fig 1;

Fig 3 is a view similar to that of Fig 1, showing a modified embodiment; and

Fig. 4 is another view similar to that of Figs 1 and 3, showing a further modified embodiment.

The low-temperature diffusion aluminizing of steels to make a pyrophorically-activated product as described in the prior art, is desirably combined with a diffusion boronizing that follows the aluminizing. The introduction of as little as 2% boron or even less, into such aluminized steels noticeably increases the pyrophoric heat evolution after the steel is subsequently activated by leaching out some of the aluminum and the thus-activated boronized steel exposed to the air.

Diffusion coating to catalytically activate the surface of a metal foam, such as nickel foam described in U.S. Patent 3,111,396, is particularly desirable inasmuch as such a foam presents a very large metal surface and does not have the fragility of thin foil or screening. The diffusion-coating treatment generally introduces into the surface of the metal being activated a relatively high concentration of an embrittling metal such as aluminum, and fragile shapes such as foil and thin screening tend to break unless very carefully handled during this treatment.

The catalytic activation of platinum and other metals of the platinum family is preferably applied to very thin substrates in the interest of reducing the amount of such expensive metals needed and here also a metal foam shape as described in U.S. Patent 3,111,396 is desirable.

To minimize having thin nickel foil rendered too fragile by the aluminizing, the diffusion step can be carried out at minimum temperatures to reduce the depth of the diffusion case. Thus a 0.1 to 0.5 mil, or even a 1 mil, case can be provided on a nickel foil 1 to 2 mils thick by aluminizing at a temperature between 650 and 800 to 900°F (343 and 427 to 482°C). The foil is increased in thickness by the aluminizing, so that a heavy aluminizing of a one-mil thick foil can yield a product 2.5 to 3 or more mils thick with each face having an aluminized case and both cases together occupying about 2 to 2.6 mils of that thickness (1 mil = 25.4 $\mu$m).

The fragility of thin foils when diffusion coated, can also be offset by having the metal of the foil in the form of a surface layer securely held on a carrier foil or sheet made of metal that does not have the objectionable fragility and can be subsequently separated from that surface layer. Thus a 5 mil thick aluminum sheet can have electroplated on one face a one mil thick layer of nickel or cobalt, using a preliminary flash coating of chromium or zinc to get the nickel or cobalt to adherently deposit. The final coated aluminum sheet is then subject to a 20-hour diffusion treatment at 750 to 850°F (399 to 454°C) in a

2

EP 0 366 784 B1

hydrogen-bathed atmosphere to cause the aluminum to diffuse most of the way through the nickel or cobalt layer, after which the resulting product is subjected to caustic leaching to dissolve the aluminum. This leaves a catalytically active nickel or cobalt foil that contains a residual small content of diffused-in-aluminum and holds itself together adequately for normal handling. Although pyrophoric, its catalytic activity is not as high as is available from a pack diffusion process without the aluminum carrier sheet, but it does a good job of catalysing hydrogenation and other chemical reactions including ammonia oxidation and HCN formation. Of particular interest, a Ni or Co plating formed by electroplating in the above manner has a particularly low density thus limiting the amount of mass needed per unit volume of catalyst.

Both faces of the aluminum sheet can be given nickel or cobalt platings in which case the corners or edges of the plated sheet can be trimmed off to expose the aluminum substrate for leaching.

A very effective zinc flash for the foregoing plating sequence is obtained by a 1/2 to 1 minute dip of the cleaned aluminum sheet at room temperature in the following solution:

| NaOH | 525 grams |
|---|---|
| ZnO | 100 grams |
| $FeCl_3.6H_2O$ | 1 gram |
| $NaKC_4H_4O_6.4H_2O$ | 10 grams |
| Water | to make one liter |

Platinum and other catalytic metals can similarly be converted to catalytic foil, and other leachable metals like zinc can be used as the supporting foil in place of aluminum. The supporting layer can also be made by spraying molten aluminum or zinc on a surface of the foil that is to be activated.

The pack diffusion to activate any of the catalysts of the present invention can be effected in one step or in multiple diffusion steps under different diffusion conditions to vary the distribution of the diffused-in metal. Regardless of how the diffusion is carried out, the pyrophoricity of the leached product can be entirely blocked by immersing the activated surface in an aqueous solution of a chromate such as an alkali metal, magnesium or ammonium chromate or chromic acid. A concentration of about 1% chromate ion is all that is needed to inhibit essentially all the otherwise intense pyrophoric activity of nickel for example, after only a few seconds contact. Smaller concentrations, as low as 0.1% chromate ion, will also be effective if kept in contact for longer times.

A catalyst so inhibited can be conveniently stored or shipped without being immersed in a protective liquid. Moreover the catalyst can subsequently be pyrophorically reactivated by merely treating it for about 2 minutes with 5% aqueous NaOH, preferably at 10°C. Rinsing away this treating liquid will then leave the catalyst with almost all of its original activity.

The chromate treatment does not significantly reduce the catalytic activity of the catalysts even though it kills the pyrophoricity. Indeed, such treatment can increase catalytic activity.

The catalytic activity withstands intense evacuation, although the activated surfaces gives off large quantities of hydrogen under the influence of the lowered pressure.

A readily ignited metal such as titanium or magnesium in foil or wire form can also be given a nickel coating, as by rolling, and the nickel coating then rendered pyrophoric. To ignite the ignitable metal, the coating should be at least about 0.4 mil thick.

The pyrophoric metals, regardless of how they are produced, can be plated as by electrolytic coatings from alkaline cyanide baths of zinc, cadmium, silver, tin or copper, without significantly diminishing their pyrophoricity. Such coatings that are over about 0.2 mil thick will significantly reduce the pyrophoric action.

Pyrophorically activated nickel and iron also retain some of the aluminum or zinc or the like used to activate them, even though these activating metals are leached out with strong hot aqueous caustic for 12 hours or more. When such leached pyrophoric products are dipped in 1 to 5% aqueous $H_2O_2$ for about 1/4 to about 1 hour, their pyrophoricity is sharply reduced or entirely eliminated. Notwithstanding such reduction, the products are still strongly catalytic. A nickel screen having forty 10 mil wires per inch, and diffusion aluminized at 950°F (510°C) for 16 hours followed by 2 hours of leaching in 20% aqueous NaOH at 180°F (82°C) with a final 30 minute dip in 2% aqueous $H_2O_2$, develops an activated case about 1.6 mils thick and shows a very low overvoltage as a cathode in electrolyzing water containing a little dissolved KOH. Although the freshly leached screen is not pyrophoric, after two to four weeks electrolyzing the water, it tends to become pyrophoric. At this point a three-hour dip in 160°F tap water will eliminate the pyrophoricity.

Although the screen pyrophoricity tends to increase while it is used as an electrolysis electrode, its catalytic effectiveness tends to very gradually drop during such use. After several years of such use, the

3

screens are desirably reactivated by subjecting them to another aluminizing treatment followed by another leaching out of aluminum. The activated surface can be removed beforehand by prolonged exposure to dilute aqueous mineral acid.

The aluminizing of the present invention can also be used to to prepare aluminized steel, iron, nickel or other substrates for conversion to Raney-type activated metals, as described in U.S. Patent 4,154,705. Both self-supporting substrates and powdered substrates can be so activated. This type of treatment provides the greatest degree of activation for foils or other self-supporting substrates when the aluminizing is effected at the lowest temperatures ---below 1000°F (538°C)--- and at such low temperatures energizers such as inexpensive ammonium halides give undesirable diffusion cases. Alumium halide activators give better results, as does water-insoluble $CrCl_3$.

The pyrophoric effects of the Raney-type activated metals is further improved by diffusing boron into the surface being activated. This is shown in the following Examples 1 and 2 which demonstrate prior art techniques for such boron diffusion :

EXAMPLE 1

Three-hundred grams of powdered 325 mesh $FeAl_2$ is thoroughly mixed with 10 grams powdered boron and 6 grams of powdered $NaBF_4$. The mixture is placed in a carbon steel retort which is then fitted into a tube furnace, and heated while a flushing gas is passed through the tube.

A heat of 1800°F (582°C) held there for 1 1/2 hours under hydrogen, introduces about 7% boron into the $FeAl_2$ powder, based on its iron content.

The retort contents are partially sintered together as a result of the diffusion heat, but can be fairly easily removed from the retort after banging the outside of the retort with hammers or mallets. Crushing and/or grinding readily reduces the mass to very small particle size. Then on leaching aluminum out of the resulting product mass as by a 60-minute treatment in 15-16% aqueous NaOH that is cooled to keep it below 120°F (49°C), followed by a washing, the activated particles remaining are quite pyrophoric and on exposure to air heat up to temperatures of about 1000°F (582°C). Higher and lower leaching concentrations and temperatures can also be used, but are less desirable.

Longer diffusion boronizing provides, after leaching, an activated iron-aluminum-boron alloy powder containing as much as 30% boron based on the weight of its iron, and which upon exposure to air heats up to over 1200°F. Boron contents greater than about 30% provide decreasing heat-up and at about 40% leave the leached powder non-pyrophoric. It is preferred that the boron penetrate through the entire thickness of each powder particle and that each particle have a uniform composition throughout its thickness.

Similar results are obtained when $FeAl_3$ powder is used in place of the $FeAl_2$, when alloys of intermediate proportions are used, and when the corresponding nickel-aluminum alloys are used. Some of the alloys are not as brittle, and therefore not as easily grindable as others. If the iron-aluminum alloy powder particles being boronized are over about 1 millimeter in size, the boronizing treatment times should be substantially lengthened to make the boron penetration complete. Other boron halides such as ammonium fluoborate, $BBr_3$ and $BI_3$ can be used as energizers. In general, the energizer content of the pack should be from about 1 to about 3% by weight, and the diffusion temperature at least about 1400°F (760 °C).

By not using an inert refractory diluent in the boronizing pack, it becomes unnecessary to later separate such diluent from the boronized powder.

The foregoing boronizing of self-supporting substrates such as foils requires much more care and should be conducted with inert refractory diluent in the pack. Thus, conducting the same boronizing on lengths of one-mil thick aluminized iron foil is awkward because such foil is extremely brittle and difficult to handle. The following is a preferred example.

EXAMPLE 2

Such boronizing can be satisfactorily effected in the following powder pack:
200 grams powdered alumina
10 grams powdered boron
5 grams sodium or ammonium fluoborate,
at 950°F (510°C) for 18 hours, or at 1050°F (566°C) for 3 hours, in a hydrogen-bathed atmosphere. The boron then penetrates about halfway through the aluminized case.

4

Aluminum loss to the boron in the pack also takes place. The aluminizing of an iron-boron alloy in an attempt to introduce sufficient aluminum to give a pyrophoric product after leaching, causes excessive loss of boron from the substrate to the pack.

The activated powders containing boron, or even free of boron, are stored out of contact with air or oxygen to preserve their pyrophoricity. Water is not a suitable preserving liquid for the activated boron-containing powders. Acetone preserves them for at least three weeks, as does an azeotropic mixture of trifluoro-trichloro ethane with methylene chloride, described in U.S. Patent 2,999,817. Ordinary fluoro-chloro ethanes and methanes that are normally used as refrigerants or propellants are also suitable and they can be used by themselves or mixed with each other or with acetone. Mixtures of the activated powders with preserving liquids that are also propellants, are particularly desirable in that they can be packed in an aerosol-type container from which they are readily discharged to provide a cloud of pyrophorically oxidizing particles.

When substantial quantities of iron and aluminum, or nickel and aluminum, powders are mixed and heated, they react with each other as the temperature reaches about 480°C and generate large quantities of heat while very rapidly forming the aluminide. Thus for continuous formation of aluminide powders, iron or nickel powders or mixtures of the two can be further mixed with the aluminum powder and then poured onto a moving conveyor of Inconel 600 for example that carries the resulting mixture through an aluminizing atmosphere where the leading edge of the mixture is heated as by a burner or oven to initiate the reaction. When the reaction starts, the burner can be turned off, and when an oven is used, the oven can be temperature-controlled to reduce or cut off the heat it supplies, at the time the reaction supplies sufficient heat.

Moving metal foils such as said Inconel, that withstand the reaction, make suitable conveyors although the reacted particles tend to adhere to such foils. Where the particles are carried by foils of stainless steel, low alloy steel or plain steel, the adhesion is quite pronounced, so that the reaction product is a foil to which the reacted particles are sintered. No other conveyor is then needed. The reaction can take place so rapidly that no special atmosphere is needed so that it can be conducted in air. A stream of argon can be directed over the exposed moving foil to displace most of the ambient air.

Nickel powder effects aluminide formation with more vigor than iron powder does, and also provides, after leaching out aluminum, a pyrophoric product having somewhat more pyrophoric heat output. The aluminide-forming reaction can seriously degrade the supporting foil when that foil is iron or other metal not very resistant to high temperatures. To minimize such degradation it is preferred that there be no more than about 2/3 atom of nickel for every atom of iron in the powder mixture, and that there be not over about 2.6 atoms of aluminum for every atom of iron and nickel. For the most effective pyrophoricity there should be at least about 2 atomsof aluminum for every atom of iron and nickel. A proportion of 1 1/2 atoms of aluminum for every atom of iron and nickel reacts to form an aluminide mixture that is slow to leach and becomes only mildly pyrophoric.

The aluminide-forming reaction proceeds very quickly after the powder mixture reaches reaction temperature. Where the powder particles are about 40 microns in size, the reaction time is generally not more than about 5 seconds and for smaller particles even less time is required. The use of a supporting foil that absorbs and/or conducts away heat very rapidly such as 0.05 millimeter thick copper, can extend the reaction duration if the powder mixture is in a layer less than about 0.1 millimeter thick. Layers at least 0.1 millimeter thick are preferred where the pyrophoricity is to attain the maximum radiation temperature.

The leaching that renders the aluminide pyrophoric is preferably carried out rapidly, as by treatment with 20% NaOH or KOH in water at about 60 to 95°C for two to three minutes. Higher leaching temperatures and/or higher caustic concentrations further shorten the leach time, but longer leach times can be used; as described in the prior art.

The aluminide-forming mixture can have additional ingredients incorporated to improve the pyrophoric output after leaching. A highly exothermic combustible material like powdered boron is very useful for this purpose, and only about 1 to about 4% of such powder in the aluminide-forming mixture is highly effective. Powdered carbon, magnesium and titanium are also useful additives, but they tend to ignite when the aluminide-forming reaction is conducted in a manner that does not completely shield the reacting mixture from the ambient air.

A preferred technique for preparing activated foil is to apply a Raney type layer to one or both faces of a foil substrate, using a sintering technique. Thus a mixture of nickel and aluminum powders the particles of which are from about 1 to about 12 microns in size, are in a proportion of 3 atoms aluminum to 1 atom nickel slurried in a 2% solution of polyethylacrylate in methyl chloroform, and the resulting slurry sprayed onto a 50 micron thick steel foil to build up a coating particle thickness of about 25 to about 50 to 100 microns on each face. The thus-coated foil is then dried to volatilize off its solvent content, and then embedded in a pack of chromium granules held in a metal retort. A stream of argon is flushed through the retort and then replaced with a stream of hydrogen, while the retort is heated to about 815°C for about 90 minutes. The retort is then cooled and the coated foils removed. They now show rough sintered-on metal faces which when leached as described above show excellent pyrophoric action.

The nickel and aluminum particles are known to inter-act very aggressively, and the retort heating time can be reduced to as little as 5 minutes or even less. It takes a very few minutes, and with the use of high temperatures only a few seconds, for the powders to reach their inter-reacting temperature of about 300 to 500° Centigrade, and once they start to inter-react they generate sufficient heat to take the coatings to about 750°C to thus complete the sintering to the substrate foil. That substrate can be as thin as 10 microns to further increase the final pyrophoric heat output.

It is not necessary to use a retort. A preheated tube through which argon or hydrogen or nitrogen, can have passed through it a foil carrying on one face the foregoing coating. In about one minute or less the nickel-aluminum reaction takes place to leave a sintered-on product that after leaching shows excellent pyrophoric action.

Steel foil is a very inexpensive substrate, but other metal substrates such as nickel or stainless steel or copper or brass foils can be used. Any substance that will withstand the treatment conditions and not disintegrate, even a carbon fiber web, is a suitable carrier substrate.

Iron powder can be substituted for the nickel powder, preferably with the iron-aluminum atom ratio of 1:2 to 1:4, and similar results are obtained.

Cobalt can also be substituted for the nickel, without changing its proportion to aluminum.

The chromium granule bed can be replaced by a bed of powdered alumina, and the hydrogen flush by a helium, or nitrogen or argon flush, without significantly altering the results. The retort atmosphere need not contain any diffusion activator to improve the sintering action.

Where a foil with only one pyrophoric surface is desired, the nickel and aluminum particles can be applied with or without a binder, to the top of a horizontally oriented substrate foil, and as above noted the powder-carrying foil heated to reaction temperature without embedding it in a pack. The retorting time for such a treatment is reduced to less than 15 seconds, inasmuch as there is no pack to heat up.

The foregoing powder-sintering techniques are particularly suited for preparing pyrophoric foil on a continuous basis. Thus a roll of 1/2, 1 or 2-mil thick substrate foil can be unspooled and passed through gas seals into and out of a heated argon or hydrogen-filled retort or tube in a relatively cool portion of which the inter-reacting powders are poured onto the foil. After the desired dwell in the hot part of the retort or tube, the coated foil is pulled out and then through a leach bath where the leaching is completed while the coated foil travels at the same rate as it does in the sintering, so that the sequence can be realistically conducted using a retort path as short as 1/2 to 1 meter to achieve a high output rate.

Where the final foil is desired to have both surfaces pyrophoric, the sintering step can be repeated with the substrate foil held upside down and a fresh sintering mixture applied to the surface that now faces upwardly. Alternatively the coating slurry can be sprayed onto both surfaces and then only one heat treatment used.

The proportions of aluminum to nickel or iron can be varied about plus or minus 20% with little loss of effectiveness. The proportion of aluminum should not be below the limit for Raney alloy. A Raney alloy is here defined as an alloy that when leached with aqueous caustic becomes pyrophoric. The sintering powder can have its nickel and iron mixed together in any proportion to vary the pyrophoric action. Also the final foil can be made with activated iron on one face and activated nickel on its other face. The activated nickel pyrophorically reacts more sharply but that reaction is completed in substantially less time, so that the dual coatings work a balancing of the reactions on their separate faces.

The foil can be perforated, as by punching out adjacent circular portions about 25 to about 150 microns in diameter. At least about 25 microns of spacing between adjacent punchings will leave sufficient metal in the powder-carrying web to provide the support needed for handling. A perforated web reduces the amount of non-pyrophoric material in the final leached product, and in this way improves the pyrophoric action.

Expanded metal is a desirable form of perforated metal.

Wire screening also makes a very desirable support web. A screen of stainless steel wires 25 to 50 microns in diameter spaced 25 to 50 microns apart is particularly strong, especially when heated to about 650°C to 825°C, so that it makes a very dependable support web for a commercial operation.

Where the web perforations are larger than the powder particles, the powder is preferably applied in slurry form as noted, so that they are better held in place. Where the perforations are close together, such a slurry need only be applied, as by spraying, on one face of the web inasmuch as some of the slurry will move through the perforations to the opposite face of the web. Dipping is also practical.

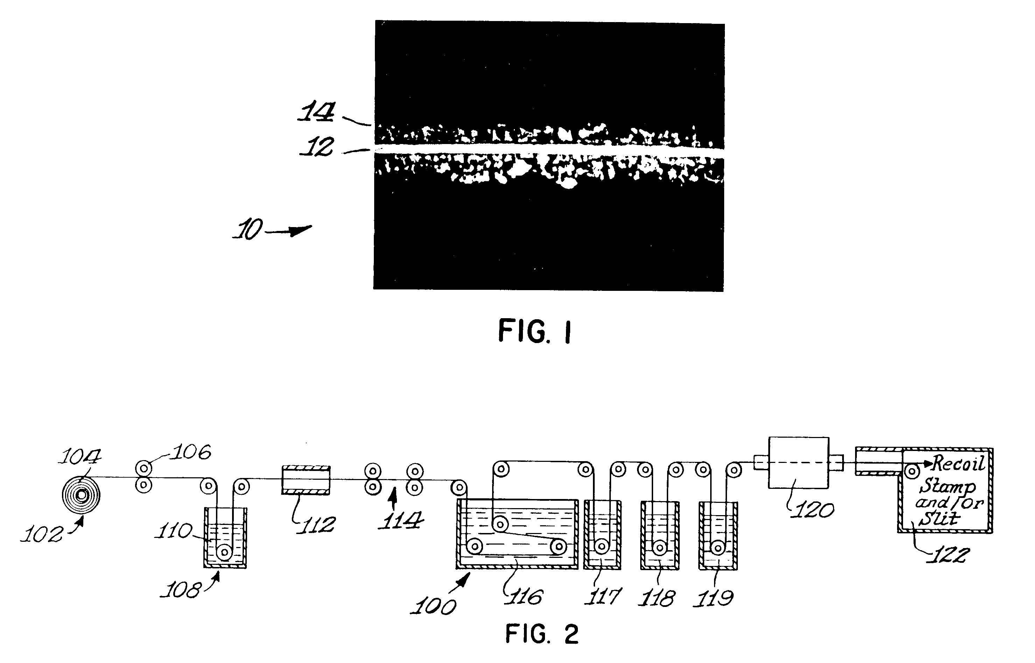

Continuous strips of pyrophoric metal are accordingly readily manufactured by feeding from a continuous coil lengths of foil, expanded metal or wire cloth past a spray gun or roller coater that applies a slurry of the foregoing powders, then through the tube of a tube furnace heated to about 500 to 1,000°C so that each increment of the slurry-carrying screening is dried and subject to that high temperature for not over about two seconds to three minutes. A protective gas such as argon or hydrogen can be flowed through the tube around the slurry-carrying web, as in Fig 1 of U.S. Patent 4,708,913.

After emerging from the heated tube, the coated web is passed through a caustic leach bath which, at about 10 to 20% NaOH concentration and about 50 to 85°C, leaches out sufficient aluminum in two to five minutes to yield a very effective pyrophoric product. Such product is illustrated in Fig 1, where 10 is the product, 12 is the carrier web, and 14 is the sintered activated powder. Although quite porous, that sintered-on mass is held in place.

Where iron powder is reacted with aluminum powder, the leach solution is preferred to also contain dissolved stannite and a little hydrogen peroxide, as described in U.S. Patent 4970114.

The foregoing coatings are openly porous in that they are composed of pyrophoric particles sintered together in spaced locations that leave spaces between the particles. In the outer portion of the coating those spaces are essentially at least as wide as the particles themselves.

The particles themselves also have a microporous structure as shown in U.S. Patent 4,154,705.

The development of the openly porous array during the leaching makes the leaching more effective, so that for coatings not over about 1/2mm thick the leaching can be completed in not over about 5 minutes, and can be as short as 2 minutes.

The openly porous coating is also readily compacted, as by passing the coated and leached web through the bight of a pair of steel rolls that are pressed together by a force of about 50 kilograms per inch of axial length. Such compacting reduces the overall thickness of the coated and leached web as much as 40 to 50 percent, and even a 20% reduction provides a compacted product that can be packed in materially higher concentration in a decoy-discharge cannister or shell.

The compacting or rolling can be effected in one or two or more steps, and does not materially loosen the coated particles.

The activated product 10 can now be cut into pieces suitable for discharging as decoy-chaff against heat-seeking missiles. The product can also be coated with materials that shift the wave length pattern of the pyrophoric radiation, as described in U.S. Patent 4,799,979.

AISI 1010 steel or iron or bronze or nickel foil, expanded or perforated metal or wire screening can be substituted for the stainless steel web, and are helpful in that they at least partially oxidize during the pyrophoric action and thus increase the pyrophoric output.

A particularly desirable technique for improving the spectral response of a pyrophoric web is to provide a face of the web with a highly specular surface which in turn has its external face coated with an alkali metal silicate. The highly specular surface can be polished metals like stainless steel, copper, aluminum or silver and should have a specular reflection of at least about 70% to red light. The alkali metal silicate preferably has an $SiO_2 : M_2O$ mol ratio between about 2 and about 5, and should be at least about 10 microns thick.

Where the pyrophoric web already contains a specularly-surface metal foil like stainless steel, the alkali metal silicate can be applied directly to that specular surface. Sodium or potassium silicates having a 3.22 mol ratio are very effective.

The specular surface can be provided by cementing a specularly-surfaced foil to a face of the pyrophoric web, or by metallizing that face with aluminum at high vacuum. High vacuum deposited aluminum flakes are available in the market place and can be deposited from suspension in a binder-containing volatilizable liquid. An aqueous solution of the alkali metal silicate can be used as a cememting material or as the above-mentioned binder. The face of the pyrophoric web to which a separate specular surface is applied, can be the face of the pyrophoric aluminides before or after rolling, and before or after leaching can be the face of a supporting foil or screen. Where a specular foil is applied, that foil should be very thin, less than about 20 microns thick.

A little boron or chromium oxide can be suspended in the alkali metal silicate to further improve the spectral response, as described infra.

As noted, the supporting foil or screen can be a highly exothermic easily ignitable metal such as zirconium or titanium, whether or not any spectral-response-adjusting coating is applied.

The powders that are sintered together can have added ingredients. Thus a little powdered $NiAl_3$ or $FeAl_3$ can be incorporated in the powder mixture, to moderate the inter-reaction with the aluminum. These high aluminides can constitute up to about 1/3 of the total powder mix.

7

There can be alternatively or additionally added powdered boron, zirconium, titanium, thermite mixture or similar additive that improves the heat generation in the pyrophoric reaction of the activated material. When boron is added, this can be done before or after the heat treatment, and preferably constitutes only about 1/2% to about 5% of the powder mix when added before the heat treatment.

The presence of at least about 0.5% boron in the powder mixture greatly improves the adhesion of the pyrophoric coat to stainless steel and to nickel, but not to plain carbon steel or iron.

The reaction between the metal powders is so rapid that it is not necessary to make absolutely certain that atmospheric oxygen be kept out of the reaction atmosphere. When the reaction is conducted by a five-second pass of the supported powders through an 800°C tube having a diameter as large as about 5 centimeters and about 50 centimeters long open at both ends, the product is not significantly adversely affected should the flow of protective gas be interrupted. The coated product will then show some signs of surface oxidation, but its pyrophoric effectiveness is not significantly diminished.

Also the supported powders as they are introduced into the reaction zone can be wet with a little water or contain some other volatilizable ingredient such as chromium chloride, that vaporizes to help provide a protective atmosphere.

The following are working examples of the sintering technique, in each of which the powder mixture was applied as a slurry:

| Example | Coating Mixture | | Support Base | Application Mode | Furnace Temperature and Time | Leach Bath and Time | Final Thickness in mm | Peak Pyrophoric Temperature |
|---|---|---|---|---|---|---|---|---|
| 3 | 23.8 g Al<br>11.2 g Ni<br>15.0 g NiAl$_3$<br>60.0 g [97%<br>[ 3% | 3-4 microns<br>10 microns<br>325 mesh<br>methyl<br>chloroform<br>polyethyl<br>acrylate | type 304<br>stainless<br>steel screen<br>325 mesh<br>3/40 mm<br>thick | Spray | 650°C<br>15 Seconds | 20% aqueous NaOH<br>93°C<br>2½ minutes | 9/40 | 900°C |
| 4 | 27.2 g Al<br>12.8 g Ni<br>10 g NiAl$_3$<br>0.5 g B<br>60 g solution of Ex 3 | 3 microns<br>10 microns<br>325 mesh<br>amorphous<br>-325 mesh | stainless<br>steel<br>foil<br>1/40 mm<br>thick | Same as for Example 3 | 815°C<br>2 seconds | Same as for Example 3 | 1/4 | 1000°C |
| 5 | Same as for Example 4 | | nickel<br>foil<br>1/20 mm<br>thick | Same as for Example 4 | | | 12/40 mm | |
| 6 | 20 g Fe<br>30 g Al<br>1 g B<br>60 g solution of Ex 3 | 4 microns<br>3-4 microns<br>amorphous<br>-325 mesh | Same as for Example 3 | | 650°C<br>1 minute | 20% aqueous NaOH<br>containing 1%<br>SnCl$_2$ 12H$_2$O<br>2½ minutes | 11/40 mm | 1050°C |

9

| Ex. | Precursor | Carrier | Application | First stage | Second stage | Loading | Final temp. |
|---|---|---|---|---|---|---|---|
| 7 | 27.0 g Al 3-4 microns<br>12.5 g Fe 4 microns<br>10.5 g Ni 10 microns<br>0.3 g B amorphous -325 mesh<br>60 g solution of Ex 3 | AISI 1010 Steel foil 1/40 mm thick | Spray | 810°C 3 minutes | Same as for Ex. 6 | 6/40 mm | 1000°C |
| 8 | Same as for Example 4 | expanded 304 stainless steel foil 3/40 mm thick with 1½ mm openings | Spray | 650°C 1 minute | Same as for Ex. 3 | 13/40 mm | 1050°C |
| 9 | Same as for Example 4 | 4/10 mm thick carbon fiber cloth | Spray | 650°C 1 minute | Same as for Ex. 3 | 5/8 mm | 975°C |
| 10 | 130 g Al 3-4 microns<br>64 g Ni 10 microns<br>44 g NiAl$_3$ -325 mesh<br>180 g Solution of Ex 3 | Screen of Example 3 | Two dips with intervening drying | 650°C 30 seconds | Same as in Ex. 3, but for 3 minutes | 8/40 mm | 850°C |
| 11 | 13.6 g Al 3-4 microns<br>6.4 g Ni 10 minutes<br>5.0 g NiAl$_3$ -325 mesh<br>15.0 g water containing 0.05 g Triton wetting agent | Screen of Example 3 | Spray two coats with intervening drying | 650°C 15 seconds | Same as in Ex. 10 | 8.5/40mm | 825°C |

A particularly desirable technique uses as a carrier inexpensive steel such as type 1010, in the form of a foil about 25 to 50 microns thick. Such a foil can be seriously embrittled by the inter-reacting metals at the high inter-reaction temperatures generated, and to avoid excessive damage, the precursor metals are applied in at least two stages, with the first stage arranged to generate relatively low inter-reaction temperatures. Thus the atomic proportion of the aluminum to the iron, nickel or cobalt precursors should be no greater than about 2, or the metal alloying with the aluminum should be mostly iron, or the precursors can be diluted with preformed alloy, or combinations of these techniques used. One desirable arrangement uses as a first stage a mixture of:

50 grams iron powder

68.4 grams aluminum powder

14.8 grams nickel powder

This mixture can be poured onto the steel foil in a layer about 75 microns thick, or suspended in a binder solution that is applied to the foil or into which the foil is dipped. A typical binder solution is a 6% solution of polyethylacrylate in methyl chloroform. The dried combination is then heated to about 700°C, setting off the reaction between the aluminum and the other metals. After about seven seconds the reaction is completed and the alloy particles formed are sintered to each other and to the foil, with the thus-coated foil retaining some of its malleability. It can for example be bent at least about 20 degrees around a mandrel 3 centimeters in diameter.

Over the reacted coating there is then applied another precursor layer, this time a mixture of

108.8 grams aluminum

51.2 grams nickel

40 grams preformed $NiAl_2$

2 grams boron

and the heat treatment repeated. The resulting coated foil can still be bent at least about 20 degrees around a mandrel 3 centimeters in diameter.

The final product, where both the precursor layers are about equal in thickness, is essentially a mixture of iron and nickel trialuminides, with a very small content of boron, sintered to aluminized iron foil. It is noted that when the precursor layers are applied by dipping, the resulting coatings are on both faces of the foil. Either way, the aluminide-coated foil is still strong enough to hold itself together and hold the aluminide particles in place. It is now leached as for example in 10% aqueous NaOH at 50 to 65°C for two to thirty minutes, preferably with tin dissolved in the leachant.

After rinsing, the leached product can be compacted between compacting rolls, and will then be about 125 to 200 microns thick. It is highly pyrophoric and for maximum pyrophoric heat output, the heat treatments are conducted in a protective atmosphere. Conducting them in air for a total time less than about 30 seconds does not materially detract from the pyrophoric heat output. It will be noted that the reacted precursor metals as well as the carrier foil are rendered pyrophoric by the leaching.

The following are very desirable exemplifications:

EXAMPLE 12

A length of SAE 1010 steel foil 1/40 millimeter thick has sprayed onto both faces a mixture of, by weight:

53.6 parts - 325 mesh aluminum powder

29.6 parts -325 mesh iron powder

16.8 parts - 325 mesh nickel powder

3.24 parts - 325 mesh boron powder

175.5 grams of the mixture were dispersed in 93 grams of a 4% solution of poly(ethyl methacrylate) in methylchloroform, and sprayed on in that form to apply coatings that yield a pyrophoric product about 17/40 millimeters thick overall.

The foil with the sprayed-on coatings was then air-dried for about one minute and the thus-dried product passed through the heated tube of a tube furnace. The tube is about 25 centimeters long and heated to about 700°C, and a slow stream of argon is introduced into the open-ended tube as the foil passes through. Part way through the tube the coated foil becomes red hot, and on emerging about 40 seconds later it has begun to cool down.

The cooled product is passed through a heated 20% solution of NaOH in water. With the solution between 60 and 95°C, only about 2 to 3 minutes in the solution yields a leached product having an exceptionally high degree of pyrophoricity. That product, which is about 17/40 millimeters thick, is further improved by rolling it down between pressure rollers to a thickness of about 1/4 millimeter.

The pyrophoric product is also improved by subjecting it, before or after rolling, to the post-treatment with citric acid or other mild acid as described in U.S. Patent 4927798.

The magnitude of the resulting improvement diminishes as the nickel-to-iron proportion increases.

The coating mixture can be applied by other techniques, such as by roller coating or by dipping the foil in a suspension of the coating mixture, or by merely pouring the powdered mixture on a surface of the foil while the foil is held with that surface extending in a horizontal plane. The binder content in the coating mixture can be reduced and even completely eliminated, particularly where only the upper face of the foil is coated. Such a one-sided coating can, after the aluminide formation, be repeated on the other face of the foil if desired.

The pyrophoric material is quite porous both before and after rolling, and can be impregnated with liquid or powdered materials as above noted that also improve the pyrophoricity, as by adding exothermic heat and/or varying the spectral response of the pyrophorically heated material.

Reducing the boron content of the original mixture to 1 part by weight, reduces the pyrophoricity somewhat. Eliminating the boron altogether, further reduces the pyrophoricity. Increasing the boron content to 6 or as much as 20 parts by weight increases the pyrophoric heat output. Powdered magnesium and/or titanium behave similarly.

It is preferred to incorporate the foregoing additive in the original powder mixture inasmuch as this reduces the intensity of the aluminide-forming reaction. However the additives can alternatively or additionally be incorporated in the leached product, as by suspending the additives as finely-divided powders in a liquid like water, and slurrying such suspension over the leached product.

The aluminide-forming reaction can alternatively be moderated by reducing the content of the nickel powder, reducing the content of the aluminum powder, or by adding diluents such as pre-formed iron or nickel aluminides, as noted.

Increasing the nickel proportion or the aluminum proportion beyond the limits set out above makes the aluminide-forming reaction so vigorous that it causes the degradation of an iron foil on which the reaction takes place. It appears that such iron foil becomes aluminized and embrittled, as well as weakened by the high temperature of the aluminide-forming heat generation. The resulting foil breaks and falls apart fairly readily.

An iron foil 1/20 millimeter thick withstands such degradation a little better than a foil half as thick, but it is preferred to keep within the limits set out above, even for the thicker foil.

EXAMPLE 13

A mixture is prepared of the following powders, each about 10 microns in particle size:

| Iron | One atom |
| Aluminum | 2.5 atoms |
| Copper | 0.1 atom |

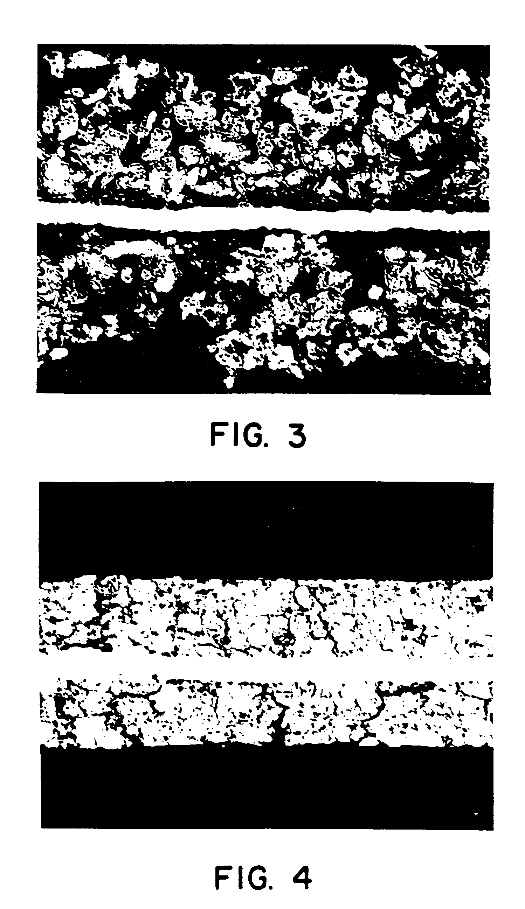

This mixture is dispersed in the binder solution of Example 12, sprayed onto both faces of its steel foil about 2.5 centimeters wide and about 25 microns thick and subjected to heat-induced reaction and subsequent leaching as in that example. The resulting product is illustrated in Fig 3, and shows very good adhesion between the aluminide particles 50 as well as between those particles and the foil 60. On flexing this product much fewer particles break off as compared to the corresponding product of Example 12.

Rolling of the Fig 3 product between steel rollers 9 centimeters in diameter biased toward each other by a force of 20 kilograms, compacts the product to the still-porous condition illustrated in Fig 4 in which its thickness has been reduced from about 425 microns to a compact 250 microns. In general such compacting is very desirable and such aluminide coatings are preferably compacted to about half to 3/4 of their original thickness.

The addition of 1 to 20% powdered boron to the initial powder mixture as in Example 12, or to the aluminide reaction product before or after leaching or after compacting, substantially increases the pyrophoric heat output of the product.

Omitting the copper from Example 13 reduces the adhesion of the iron aluminide particles or of nickel aluminide particles to iron and steel foils. At least about 1/30 atom of copper for each atom of iron and nickel, will provide such increased adhesion, and more than 1/4 atom of copper is not desirable.

Foils of low alloy steels, i.e., iron alloyed with not over 5% other metals, behave like SAE 1010 steel and like Armco iron, in respect of their poor resistance to the aluminide-forming reaction heat.

The hot aluminide-carrying foil can be directly introduced into the leaching bath before the foil cools down to the bath temperature. Due to its large surface-to-mass ratio, only about 15 to 20 seconds cooling will get it down to a temperature at which it does not cause violent localized boiling as it enters the bath particularly if the cooling is aided by a blanketing stream of cool protective gas like argon or nitrogen. The leached product is preferably between about 0.3 and 0.7 millimeters thick.

An alternative method of preparing the activated foils would be to apply on a metal foil or gauze carrier, as by Schoop spray, an adherent coating of iron and nickel aluminides having a sufficiently high aluminum content, and then subjecting such aluminide-carrying webs to the leaching treatment that extracts-aluminum and develops pyrophoricity.

Inasmuch as the leaching reduces the adhesion, the coated web is preferably heat treated at a temperature of 700°C or higher to increase the adhesion before leaching. It is also preferred to keep the aluminum proportion to between 1 1/2 and 2 atoms for every atom of iron and nickel. Before leaching, the coated web can be between about 25 and about 400 microns thick, but thicknesses not over about 50 microns are preferred inasmuch as they leach through much more readily. The foil or gauze should be as thin as practical, generally less than 25 microns thick.

The leaching should remove about 1/2 to about 3/4 of the aluminum in the aluminide or should proceed until the leaching reaction slows down to an insignificant rate. Thus a 13 micron thick iron foil coated with $FeAl_2$ to a total thickness of 50 microns will be adequately leached through in about 5 minutes or less by a 20% solution of NaOH or KOH in water at a temperature at least as high as 60°C. At boiling temperature or with higher concentrations of caustic, the leaching only takes about two minutes.

After leaching, the leached web is pyrophoric and should be kept out of contact with oxygen or air until ready for use. It can be rinsed with water and then subjected to the mild acid treatment noted above.

The leached foil is sufficiently porous to pick up 1 to 2% very finely divided boron powder from a slurry in water or methylchloroform. Adding about 1% resin binder to such slurry helps with the boron pick-up and also causes some boron powder to adhere to the outer face of the foil.

Alloying from about 1 to about 10% boron in the original aluminide foil makes it unnecessary to add boron by an after-treatment. Such alloying can be conventional melt alloying, or diffusion boronizing.

Before or after activation the foils can be cut into strips suitable for use as heat-seeking missile decoys. Cutting after activation is preferably conducted under water or in an argon or nitrogen box.

Alternatively small strips of the original aluminide foil can be prepared and they can be leached as by loading them in a perforated basket which is then lowered into the leaching bath for the appropriate time. Upon completion of the leaching, the strips can be rinsed as by lowering the basket into rinse water. After the rinsing the basketful of strips can be dipped into the mild acid bath that increases their pyrophoricity, and then again rinsed.

The original small strips of foil can be prepared for treatment by cutting up a long foil or by forming the strips from molten aluminide as described for instance in U.S. Patent 4,755,353.

The pyrophoric material should be kept away from oxygen, as by being thoroughly wet with water or other protective liquid, to preserve it against changes. It can be cut to short lengths for loading into a decoy shell used for protecting aircraft against heat-seeking missiles. It can also be stabilized by contacting it with very low concentrations of oxygen, as described in U.S. Patent 4,820,362 to render it non-pyrophoric unless heated to above 50°C.

Paper made of interfelted carbon fibers also makes a satisfactory carrier web. The reacted particles adhere to such web even though the web does not have significant porosity.

Turning now to Fig 2, this schematically shows a production line 100 having a number of stations through which work is continuously moved to produce a pyrophoric product. An uncoiling station 102 has a coil 104 of carrier substrate that is uncoiled by feed rollers 106, and fed through a coating station 108 where it is dipped in a slurry 110 of powder to be reacted. Upon leaving the slurry the powder-carrying substrate is moved through reactor 112 where it is heated to reaction temperature, after which it moves through an open space 114 where the reacted product cools and then moves through leach tank 116. After the leach, the leached product is rinsed by passing through water in tanks 117, 118 and 119, and it can then be passed through a top coating and/or compacting station 120 before it goes into receiving chamber 122 where it can be recoiled, and/or severed into the small discs or the like usually loaded into decoy shells. The severing can be accomplished while the product is still quite wet with rinse water, so that it is not contacted by air. The container can be fitted with a supply of heated or unheated argon or the like that flows out the wet product inlet to help dry the product. Drying can be effected before station 120 or before chamber 122 in which event an inert atmosphere should protect the dry product.

As top coatings to help provide good spectral distribution of the radiated heat, mixtures of boron and silicon are very effective when the silicon is from about equal to the boron content up to about 19 times that content. Top coatings less than about 10 microns thick do not materially interfere with the pyrophoric action.

For some purposes it is helpful to have pyrophoric decoy pieces that when discharged into the air from a rapidly moving aircraft, do not immediately slow down and stop their discharge movement. To this end the pieces can be contained in a wire netting that permits them to spread out to only about 1 meter when discharged. Alternatively or additionally, the decoy pieces can be made so that their air resistance is small and intertia high. Thus the carrier web can be tantalum, silver or lead foil as much as 3/4 mil thick, and only about 1 square centimeter discs. Silver webs also contribute very good electrical conductivity that provides the pieces with an electrical dipole that helps decoy against radar signals. Copper has a similar dipole effect.

The decoying action can be modified by arranging for a succession of decoy charges to be expelled by a moving aircraft in 20 to 30 second intervals, for example. This appears to a heat-seeking missile as a series of hot clouds that move with the aircraft, and thus becomes a more attractive decoy target.

The pyrophoric product is also a very effective catalyst for different kinds of chemical and electrochemical reaction, such as electrolysis of water with very low over-voltages, ammonia oxidation, CO oxidation and NOX removal. This catalytic quality remains essentially unaffected after the pyrophoric product is permitted to undergo its pyrophoric reaction with air.

Obviously many modifications and variations of the present invention are possible in the light of the above teachings. It is, therefore, to be understood that within the scope of the appended claims the invention may be practiced otherwise than as specifically described.

## Claims

1. A process for preparing a length of pyrophoric material, comprising the steps of providing a length of a carrier in the form of a web or foil not over about 3/4 millimeter thick, applying to the carrier a layer at least about 1/50 millimeter thick of a mixture of aluminium powder and nickel, iron or cobalt powder, the powders being in the proportion of a Raney alloy, and the powder particles being sufficiently small to essentially completely interact when heated, heating the carrier to cause the powder particles to essentially completely interact to form aluminides that are sintered together and adhere to the carrier, the latter being sufficiently heat resistant so that it is not disintegrated by the process and leaching some of the aluminium from the aluminides to form the pyrophoric material.

2. The process of claim 1 in which the heating is for a time of from about 2 seconds to about three minutes.

3. The process of claim 1 or 2 in which the heating step is followed by a caustic leach to convert the interacted mixture into pyrophoric material.

4. The process of claim 3 in which after the conversion into pyrophoric material, the carrier-supported pyrophoric material is cut into pieces suitable for decoying heat-seeking missiles.

5. The process of any preceding claim, in which the carrier is perforated and the powder mixture is applied as a slurry in a binder-containing liquid.

6. The process of claim 5 in which the carrier is a length of screening.

7. The process of any one of claims 3 to 6 in which the powder mixture also contains about 1/2% to about 5% boron.

8. The process of any preceding claim in which the length of carrier is continuous.

9. The process of any one of claims 3 to 8 in which the leached product is subjected to a compaction step to reduce the overall thickness of and compact the leached layer.

10. The process of any one of claims 1 to 5 in which the carrier is metal foil not over about $\frac{1}{4}$ millimeter thick.

11. The process of claim 1, wherein plain carbon steel foil not over 50 microns thick is used as the carrier, and the powdered Raney precursor metals are sintered to the foil in at least two stages.

12. The process of claim 1, wherein the carrier web is a metal foil about 0.02 to about 0.05 millimeters thick and the layer is a mixture of powdered aluminium, iron and nickel such that there is no more than about 2/3 atoms of nickel for every atom of iron in the powder mixture, and not over about 2.6 atoms of aluminium for every atom of iron and nickel, which mixture is applied to the surface of the foil and then heated to cause the powders to inter-react without materially degrading the foil, to form iron and nickel aluminides having at least twice as many aluminium atoms as nickel and iron atoms, the aluminides being sintered together and to the foil, and the resulting foil is leached to remove some of the aluminium from the aluminides and thus to develop pyrophoricity.

13. The process of claim 12 in which the powder mixture has not more than about 2.6 atoms of aluminium for each atom of iron and nickel.

14. The process of claim 12 or 13, in which the powder mixture also contains powdered boron in an amount about 1 to about 4% by weight.

15. The process of any preceding claim, wherein said Raney alloy contains at least about 2 atoms of aluminium for every atom of iron and nickel.

16. A pyrophoric foil having a core web or foil not over about 3/4 mm thick to which is anchored a layer at least about 1/50 mm thick, the layer being an openly porous array of pyrophoric aluminide particles sintered together, the particles themselves having a microporous structure.

17. The pyrophoric foil of claim 16 in which the particles are sintered to the core web or foil.

18. The pyrophoric web or foil of claim 16 in which the web or foil is fenestrated and the particles penetrate through the openings therein.

19. The pyrophoric web or foil of any of claims 16 to 18 in which the core web or foil is metal and is not over about 1/10 mm thick.

**Patentansprüche**

1. Ein Verfahren zur Herstellung eines Abschnittes pyrophoren Materials mit den Verfahrensschritten:
   auf einen Abschnitt eines Trägers in Form eines Bandes oder einer Folie von nicht über ungefähr 3/4 mm Dicke wird eine Schicht von mindestens ungefähr 1/50 mm Dicke einer Mischung aus Aluminiumpulver mit Nickel-, Eisen- oder Kobaltpulver aufgebracht, wobei die Pulver im Verhältnis einer Raney-Legierung vorliegen und die Partikel der Pulver ausreichend klein sind, um bei Erwärmung praktisch vollständig aufeinander einzuwirken,
   der Träger wird erhitzt, um zu bewirken, daß die Pulverpartikel praktisch vollständig aufeinander einwirken, um Aluminide zu bilden, die miteinander versintert sind und dem Träger anhaften, wobei der Träger eine ausreichende Wärmefestigkeit aufweist, so daß er nicht während des Verfahrensablaufes verfällt und
   ein Teil des Aluminiums wird aus den Aluminiden herausgelaugt, um das pyrophore Material zu bilden.

2. Verfahren nach Anspruch 1, bei dem die Erhitzung von ungefähr zwei Sekunden bis ungefähr drei Minuten dauert.

3. Verfahren nach Anspruch 1 oder 2, bei dem auf die Erhitzung ein kaustisches Auslaugen folgt, um die Mischung, deren Bestandteile aufeinander einwirkten, in ein pyrophores Material umzuwandeln.

4. Verfahren nach Anspruch 3, bei dem nach der Umwandlung in pyrophores Material das durch den Träger gehaltene pyrophore Material in Stücke geschnitten wird, die geeignet sind, wärmesuchende Projektile einzufangen.

5. Verfahren nach einem der vorhergehenden Ansprüche, bei dem der Träger perforiert ist und die Pulvermischung in Form einer Aufschlämmung in einer ein Bindemittel enthaltenden Flüssigkeit aufgebracht wird.

6. Verfahren nach Anspruch 5, bei dem der Träger ein Abschnitt eines Siebes ist.

7. Verfahren nach einem der Ansprüche 3 bis 6, bei dem die Pulvermischung auch noch ungefähr 1/2 % bis ungefähr 5 % Bor enthält.

8. Verfahren nach einem der vorhergehenden Ansprüche, bei dem der Trägerabschnitt zusammenhängend ist.

9. Verfahren nach einem der Ansprüche 3 bis 8, bei dem das ausgelaugte Produkt einer Verdichtungsphase unterworfen wird, um die gesamte Dicke der ausgelaugten Schicht zu reduzieren und die Schicht zu verdichten.

10. Verfahren nach einem der Ansprüche 1 bis 5, bei dem der Träger aus einer Metallfolie von nicht über ungefähr 1/4 mm Dicke besteht.

11. Verfahren nach Anspruch 1, bei dem als Träger eine Folie aus unlegiertem Kohlenstoffstahl mit einer 50 Mikron nicht übersteigenden Dicke verwendet wird und daß die pulverisierten Raney-Vorläufermetalle in mindestens zwei Stufen der Folie angesintert werden.

12. Verfahren nach Anspruch 1, bei dem das Trägerband eine Metallfolie von ungefähr 0,02 bis ungefähr 0,05 mm Dicke ist, und die Schicht aus einer Mischung von pulverisiertem Aluminium, Eisen und Nickel besteht, bei der nicht mehr als ungefähr zwei Drittel Nickelatome auf jedes Eisenatom in der Pulvermischung und nicht über ungefähr 2,6 Aluminiumatome auf jedes Eisen- und Nickelatom kommen, bei dem die Mischung auf die Oberfläche der Folie aufgebracht und anschließend erhitzt wird, um zu bewirken, daß die Pulver aufeinander einwirken, ohne daß die Folie stofflich abgebaut wird, um Eisen- und Nickelaluminide zu bilden, die mindestens zwei mal so viele Aluminiumatome als Nickel- und Eisenatome enthalten, und bei dem die Aluminide zusammen- und der Folie angesintert werden, bei dem die hierbei erhaltene Folie ausgelaugt wird, um einen Teil des Aluminiums aus den Aluminiden zu entfernen und auf diese Weise Pyrophorität herbeizuführen.

13. Verfahren nach Anspruch 12, bei dem die Pulvermischung nicht mehr als ungefähr 2,6 Atome Aluminium, bezogen auf jedes Eisen- und Nickelatom, enthält.

14. Verfahren nach Anspruch 12 oder 13, bei dem die Pulvermischung ferner pulverisiertes Bor in einem Mengenanteil von ungefähr 1 bis 4 Gewichtsprozent enthält.

15. Verfahren nach einem der vorhergehenden Ansprüche, bei dem die Raney-Legierung mindestens ungefähr 2 Aluminiumatome pro jedem Eisen- und Nickelatom enthält.

16. Pyrophore Folie mit einem als Kern dienenden Band oder einer Folie, deren Dicke ungefähr 3/4 mm nicht übersteigt, auf denen eine Schicht, deren Dicke mindestens ungefähr 1/50 mm beträgt, verankert ist, die aus einer offenporigen Gruppierung von zusammengesinterten pyrophoren Aluminidpartikeln gebildet ist, wobei die Partikel selbst eine mikroporöse Struktur aufweisen.

17. Pyrophore Folie nach Anspruch 16, bei der die Partikel dem Kernband oder der Kernfolie angesintert sind.

18. Pyrophores Band oder Folie nach Anspruch 16, bei denen das Band oder die Folie mit Öffnungen versehen sind und die Partikel durch die Öffnungen hindurchdringen.

19. Pyrophores Band oder Folie nach einem der Ansprüche 16 bis 18, bei denen das Kernband oder die Kernfolie aus Metall bestehen und nicht über ungefähr 1/10 mm dick sind.

**Revendications**

1. Procédé de préparation d'une longueur de matière pyrophorique, consistant à utiliser une longueur d'un support sous la forme d'une nappe ou d'un film d'une épaisseur non supérieure à environ 3/4 de millimètre, à appliquer au support une couche d'une épaisseur de moins environ 1/50e de millimètre d'un mélange de poudre d'aluminium et de poudre de nickel, de fer ou de cobalt, les poudres étant présentes dans la proportion d'un alliage de Raney, et les particules de poudre étant suffisamment petites pour interagir de manière essentiellement complète lorsqu'elles sont chauffées, à chauffer le support pour amener les particules de poudre à interagir de manière sensiblement complète pour former des aluminures qui sont frittés les uns avec les autres et adhèrent au support, ce dernier étant

16

suffisamment résistant à la chaleur pour qu'il ne soit pas désintégré au cours du procédé et à lixivier une partie de l'aluminium des aluminures pour former la matière pyrophorique.

2. Procédé selon la revendication 1, dans lequel le chauffage se fait pendant une période d'environ 2 secondes à environ 3 minutes.

3. Procédé selon la revendication 1 ou 2, dans lequel le stade de chauffage est suivi d'une lixiviation dans une substance caustique pour convertir le mélange qui a interagi en matière pyrophorique.

4. Procédé selon la revendication 3, dans lequel, après la conversion en matière pyrophorique, la matière pyrophorique supportée par le support est découpée en pièces convenant comme leurres pour les missiles à tête chercheuse.

5. Procédé selon l'une quelconque des revendications précédentes, dans lequel le support est perforé et le mélange de poudres est appliqué sous la forme d'une suspension dans un liquide contenant un liant.

6. Procédé selon la revendication 5, dans lequel le support est une longueur de tamis.

7. Procédé selon l'une quelconque des revendications 3 à 6, dans lequel le mélange de poudres contient également environ 1/2 % à environ 5 % de bore.

8. Procédé selon l'une quelconque des revendications précédentes, dans lequel la longueur de support est continue.

9. Procédé selon l'une quelconque des revendications 3 à 8, dans lequel le produit lixivié est soumis à un stade de compactage pour réduire l'épaisseur globale de la couche lixiviée et compacter celle-ci.

10. Procédé selon l'une quelconque des revendications 1 à 5, dans lequel le support est un film métallique qui a une épaisseur non supérieure à environ 1/4 de millimètre.

11. Procédé selon la revendication 1, dans lequel on utilise comme support un film d'acier au carbone standard d'une épaisseur qui n'est pas supérieure à 50 $\mu$ et les métaux précurseurs de Raney en poudre sont frittés sur le film dans au moins deux stades.

12. Procédé selon la revendication 1 dans lequel la nappe de support est un film métallique d'environ 0,02 à environ 0,05 millimètre d'épaisseur et la couche est un mélange d'aluminium de fer et de nickel en poudre de telle sorte qu'il n'y ait pas plus d'environ 2/3 atomes de nickel pour chaque atome de fer dans le mélange de poudres, et pas plus d'environ 2,6 atomes d'aluminium pour chaque atome de fer et de nickel, ledit mélange est appliqué à la surface de la feuille, puis chauffé pour amener les poudres à interagir sans dégrader matériellement le film, pour former des aluminures de fer et de nickel ayant au moins deux fois autant d'atomes d'aluminium que d'atomes de nickel et de fer, les aluminures étant frittés l'un avec l'autre et au film, et le film obtenu étant lixivié pour éliminer une partie de l'aluminium des aluminures et développer ainsi un caractère pyrophorique.

13. Procédé selon la revendication 12, dans lequel le mélange de poudres n'a pas plus d'environ 2,6 atomes d'aluminium pour chaque atome de fer et de nickel.

14. Procédé selon la revendication 12 ou 13, dans lequel le mélange de poudres contient également du bore en poudre en quantité d'environ 1 à environ 4 % en poids.

15. Procédé selon l'une quelconque des revendications précédentes, dans lequel ledit alliage de Raney contient au moins environ 2 atomes d'aluminium pour chaque atome de fer et de nickel.

16. Film pyrophorique ayant une nappe ou un film central(e) d'une épaisseur qui ne dépasse pas environ 3/4 de millimètre et sur lequel est ancrée une couche d'au moins une épaisseur d'environ 1/50e de millimètre, la couche étant constituée d'un réseau à pores ouverts de particules d'aluminures pyrophoriques frittées les unes avec les autres, les particules elles-mêmes ayant une structure microporeuse.

17

**17.** Film pyrophorique selon la revendication 16, dans lequel les particules sont frittées sur la nappe ou le film central(e).

**18.** Nappe ou film pyrophorique selon la revendication 16, dans laquelle (lequel) la nappe ou le film a des ouvertures et les particules pénètrent à travers ces ouvertures.

**19.** Nappe ou film selon l'une quelconque des revendications 16 à 18, dans laquelle (lequel) la nappe ou le film central(e) est métallique et a une épaisseur qui ne dépasse pas environ 1/10e millimètre.

FIG. 1

FIG. 2

FIG. 3

FIG. 4